# DEMANDE DE BREVET EUROPEEN

(11) **EP 1 715 462 A1**
(43) Date de publication de la demande: **25.10.2006**
(21) Numéro de dépôt: 06112540.7
(22) Date de dépôt: 12.04.2006
(51) Int. Cl.: G07C 9/00, H04B 13/00, H03K 17/96, G06K 7/08

(54) **Procédé et dispositif d'identification, notamment pour l'identification d'un propriétaire d'un véhicule**

(30) Priorité: 19.04.2005 FR 0503901
(71) Demandeur: VALEO SECURITE HABITACLE S.A.S., 94042 Créteil Cédex (FR)
(72) Inventeur: Huth, Jean-Claude c/o VALEO SECURITE HABITACLE, 94042, Creteil (FR)
(74) Mandataire: Gavin, Pablo

(57) **Abrégé**

Procédé d'identification d'un porteur (1) de badge (2) relativement à un véhicule (3), le véhicule comprenant une électrode de contact (4) accessible au contact du porteur, caractérisé en ce que :
- on compare un premier seuil (C1) avec une capacitance (C) entre l'électrode et une masse; et,
- si la capacitance est supérieure au premier seuil, on émet (101) des premières données d'identification depuis l'unité centrale (8) vers le badge.

L'invention porte aussi sur un dispositif pour mettre en oeuvre le procédé.

## Description

La présente invention se rapporte à un procédé et à un dispositif d'identification, notamment un dispositif d'identification par badge, notamment pour l'identification du propriétaire d'un véhicule, pour l'ouverture ou le démarrage du véhicule.

Les simples clefs mécaniques, autrefois utilisées pour l'ouverture et le démarrage des voitures, ont été remplacées par des clefs comprenant une télécommande, l'appui sur un bouton déclenchant l'ouverture des portes. Plus récemment, des badges électroniques ont été prévus pour que lorsque le porteur s'approche de sa voiture, et sans que le porteur n'ait à faire un geste ni même à saisir le badge, ce dernier signale à la voiture sa présence, ce qui déclenche l'ouverture des portières.

Cette dernière technologie, bien que présentant un grand progrès en termes de confort, présente encore quelques inconvénients en termes de sécurité. Par exemple, compte tenu de la portée nécessairement assez important de ce type de matériel, le porteur du badge peut être à une distance notable du véhicule et c'est quelqu'un d'autre qui peut profiter de l'ouverture pour s'y introduire.

Le but de l'invention est de proposer un dispositif d'identification présentant un haut niveau de sécurité, permettant de s'assurer que s'est bien le porteur du badge qui est identifié et que s'est bien pour lui que, par exemple, le véhicule est ouvert ou démarré.

Selon un objet de l'invention, un tel procédé d'identification d'un porteur de badge relativement à un véhicule comprenant une électrode de contact accessible au contact du porteur, est caractérisé en ce que :
- on compare un premier seuil avec une capacitance entre l'électrode et une masse; et,
- si la capacitance est supérieure au premier seuil, on émet des premières données d'identification depuis une unité centrale vers le badge.

Ces premières données d'identification sont avantageusement émises par conduction au travers du corps du porteur du badge, de sorte, notamment qu'elles peuvent difficilement être interceptées ou contrefaites par une personne mal intentionnée.

On peut aussi comparer la capacitance avec un deuxième seuil, puis :
- si la valeur de capacitance est supérieure au deuxième seuil, on règle la puissance maximale de transmission des premières données à une première valeur maximale de transmission ;
- si la valeur de capacitance est comprise entre le premier seuil et le deuxième seuil on règle la puissance maximale de transmission des premières données à une deuxième valeur maximale de transmission, la deuxième valeur maximale étant supérieure à la première valeur maximale;
- puis, on transmet les premières données d'identification, jusqu'à ce que l'on reçoive des deuxièmes donnée d'identifications ou qu'un temps limite soit atteint.

En limitant la puissance et la durée d'émission, on limite la consommation énergétique du dispositif et on limite le risque que ce ne soit pas le porteur du badge qui provoque le contact puis par exemple l'ouverture du véhicule, notamment si le porteur du badge est proche de la personne ayant provoqué le contact, ou touche cette personne.

La puissance de transmission peut être progressivement augmentée jusqu'à réception des deuxièmes données d'identification ou jusqu'à atteindre la puissance de transmission maximale.

Lorsque le badge reçoit les premières données d'indentification, et si les premières données sont « vraies », il émet des deuxièmes données d'identification sous forme d'ondes radios. Et, si les deuxièmes données d'identification sont « vraies », on déclenche une action. Cette action peut être une action de déverrouillage, notamment une action de démarrage ou d'ouverture pour le véhicule.

Par ailleurs, un dispositif d'identification pour le porteur d'un badge relativement à un véhicule est caractérisé en ce que le dispositif comprend une électrode de contact prévue pour être disposée accessible au contact du porteur, et un capteur, le capteur comprenant des moyens pour comparer un premier seuil avec une valeur de capacitance entre l'électrode et une masse du véhicule, généralement la carrosserie du véhicule. Le dispositif peut en outre comprendre une unité centrale, l'unité centrale comprenant des moyens pour émettre des premières données d'identification vers un badge. Ces moyens d'émission sont avantageusement conçus pour émettre les premières données d'identification par conduction au travers de l'électrode de contact, et donc à travers le corps en contact avec l'électrode.

Le capteur peut avantageusement, pour les raisons déjà dites, comprendre des moyens pour comparer la valeur de la capacitance à un deuxième seuil et des moyens pour régler une puissance maximale d'émission des premières données d'identification de sorte que :
- si la valeur de capacitance est supérieure au deuxième seuil, la puissance maximale de transmission des premières données est égale à une première valeur maximale de transmission ;
- si la valeur de capacitance est comprise entre le premier seuil et le deuxième seuil la puissance maximale de transmission des premières données est égale à une deuxième valeur maximale de transmission, la deuxième valeur maximale étant supérieure à la première valeur maximale;

Le badge comprend avantageusement des moyens de stockage de deuxièmes données d'identification et des moyens d'émission pour les deuxièmes données d'identification sous forme d'ondes radios.

L'unité centrale peut encore comprendre des moyens pour déclencher, au moins indirectement, une action si les deuxièmes données d'identifications sont vraies. Ainsi, il peut être prévu si le dispositif est monté sur un véhicule préalablement équipé d'une télécommande, sur laquelle on appuie pour déclencher l'action, que l'unité centrale comprenne des moyens pour émettre des ondes adaptées pour commander un récepteur de la télécommande. Le récepteur pouvant déclencher, par exemple une action d'ouverture des portières.

Notamment dans le cas de l'installation sur un véhicule existant, il peut être particulièrement avantageux que le capteur et/ou l'unité centrale soient alimentés de façon autonome, notamment par pile.

D'autres particularités et avantages de l'invention ressortiront encore de la description ci-après, relative à des exemples non limitatifs.

Aux dessins annexés :
- la figure 1 est la représentation d'un porteur de badge s'identifiant, selon l'invention, auprès d'un véhicule automobile ;
- la figure 2 est une représentation schématique de la circulation électrique dans un dispositif selon l'invention ;
- la figure 3 est une illustration d'un processus d'identification selon l'invention ; et,
- la figure 4 illustre un mode de réalisation pour un dispositif selon l'invention prévu pour être rapporté sur un véhicule non équipé d'un tel dispositif.

Dans l'exemple illustré, l'invention est utilisée pour l'ouverture d'une portière d'un véhicule. Selon le même principe, l'invention pourrait en outre être notamment utilisée pour remplacer une clef de contact et le démarrage du véhicule.

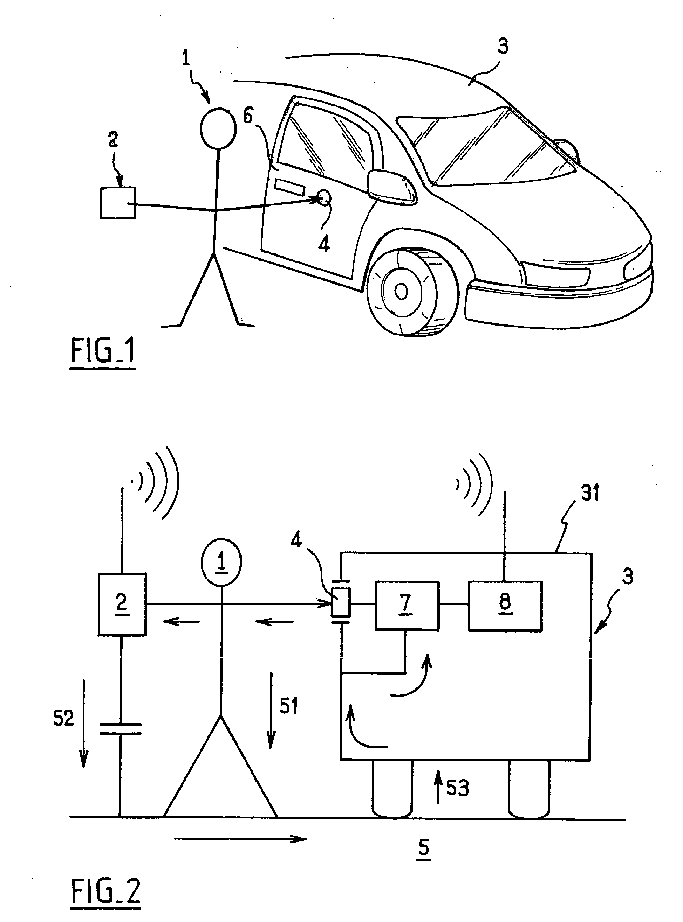

La figure 1 représente une personne 1 (ci-après le porteur), porteuse d'un badge 2, auprès d'un véhicule 3. Le badge 2 comprend des données d'identification. Il est représenté, pour schématiser, à la main du porteur. Il peut cependant, et généralement c'est le cas, être dans la poche d'un vêtement, dans une pochette ou dans un sac à main. Le vêtement, la pochette ou le sac doit cependant être effectivement porté par le porteur 1, de sorte qu'une certaine continuité électrique soit effective entre le corps du porteur et le badge 2. Sur la figure 1, le porteur 1 est représenté touchant de la main une électrode de contact ayant la forme d'une pastille 4 insérée dans une portière 6 du véhicule et électriquement isolée de cette portière. Le contact du porteur sur la pastille 4 permet, après identification, l'ouverture de la portière 6. Le contact entre le porteur et la pastille peut se faire directement, par exemple la peau d'un doigt posé sur la pastille, ou, si le porteur a des gants, au travers de ceux-ci.

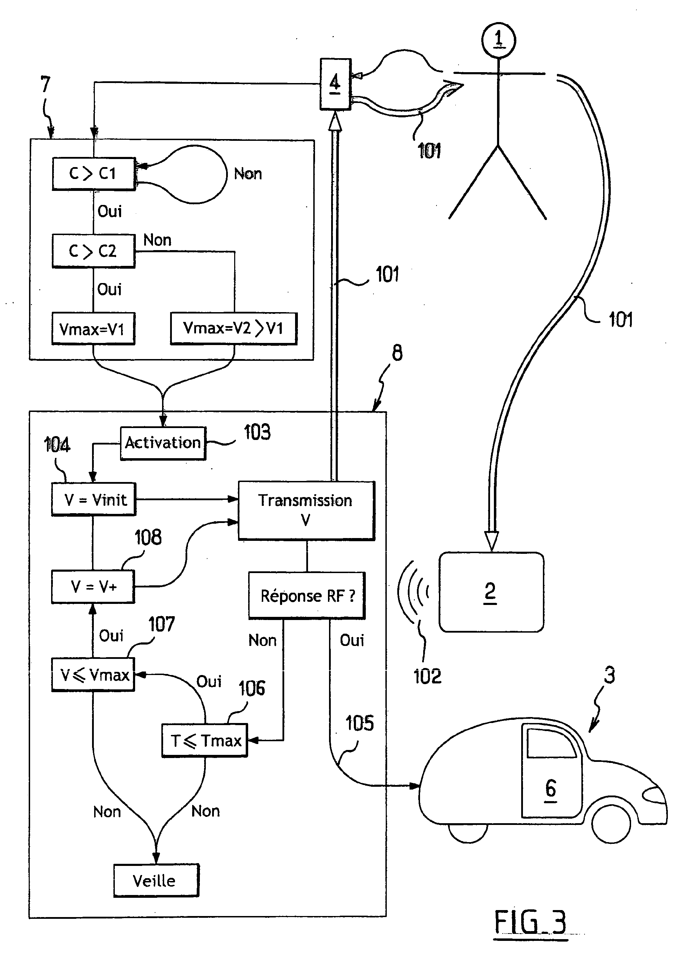

On va maintenant décrire le fonctionnement général du dispositif selon l'invention en référence aux figures 2 et 3.

Un capteur capacitif 7, détermine la capacitance C entre la carrosserie 31 du véhicule 3 et la pastille de contact 6, dans un circuit électrique comprenant notamment :
- la pastille de contact ;
- le corps du porteur ;
- le badge ;
- les vêtements et accessoires (veste, sac, gants ...) assurant la continuité électrique entre le corps du porteur et le badge et/ou la pastille de contact ;
- le sol 5, en liaison capacitive 52 avec le badge 2 ;
- le sol, en liaison électrique 51 avec le porteur 1, en parallèle avec la précédente ;
- la masse du véhicule formée principalement par la carrosserie 31, en liaison électrique 53 avec le sol, notamment au travers des pneus.

Lorsque une main s'approche du véhicule, la capacitance C mesurée par le capteur 7 augmente. Ainsi, il est prévu une valeur de seuil C1 valeur en dessous de laquelle on considérera qu'il n'y a pas de contact entre le porteur 1 et la pastille 4.

Tant que la capacitance reste en dessous du seuil C1, aucune opération autre qu'une veille permanente du capteur ne sera effectuée.

Lorsque le contact est considéré établi par le capteur 7, c'est-à-dire lorsque la capacité est supérieure au seuil, une unité centrale vérifie si la personne qui a établi ce contact est bien porteuse d'un badge et, si c'est le cas, vérifie les données d'identification du badge. L'unité centrale 8 reste en veille jusqu'à ce qu'elle soit activée par le capteur 7 lors de la détection du contact. L'unité centrale 8 émet alors à destination du badge un signal porteur de premières données d'identifications. Le badge reconnaît la présence de l'unité centrale 8, et émet à son tour, à destination de l'unité centrale, des deuxièmes données d'identifications qui lui permettent d'être reconnu par l'unité centrale 8.

Les premières données sont émises par conduction 101, notamment au travers du corps du porteur 1, ce qui implique un contact suffisant avec la pastille de contact 4 et augmente la sécurité du dispositif. Les premières données d'identification n'étant émises que s'il y a contact, le risque de méprise, par exemple le risque d'ouverture sans que le porteur n'en ait la volonté ou même sans qu'il s'en aperçoive, est donc nettement réduit par rapport aux techniques de l'art antérieur.

Par ailleurs, le badge n'émet les deuxièmes données 102 que s'il a reçu des premières données d'identifications « vraies », c'est-à-dire reconnues par le badge comme appartenant à une unité centrale avec laquelle il est apparenté, c'est-à-dire avec laquelle il est prévu de fonctionner. Ceci est un mode de fonctionnement très économique en énergie pour le badge.

Comme particulièrement représenté à la figure 3, il peut être utilisé plusieurs seuils C1,C2 de capacitance. Ainsi, si la capacitance C est supérieure à un deuxième seuil C2, lui-même supérieur au premier seuil C1, cela signifie que le contact est très bon, par exemple que le porteur n'a pas de gants. Dans ce cas une puissance maximale d'émission Vmax pour les premières données peut être réduite à un premier niveau V1. Dans un deuxième cas, si la capacitance est comprise entre les deux seuils C1,C2 la puissance d'émission maximale Vmax est augmentée à un deuxième seuil V2. La puissance maximale Vmax est déterminée par le capteur 7. Ainsi, si la capacitance C est au moins supérieure à C1, donc s'il y a eu un contact suffisant, le capteur 7 active 103 l'unité centrale et lui transmet la valeur de puissance maximale Vmax préalablement définie. L'unité centrale est activée pour un temps Tmax limite prédéfini.

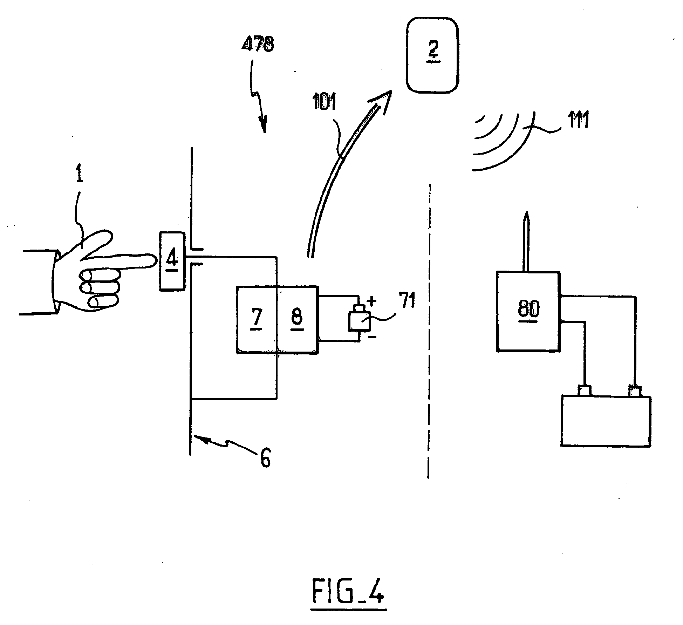

Lors de l'activation 103, la puissance d'émission est d'abord fixée 104 à une valeur initiale Vinit inférieure à Vmax. Ainsi, on teste d'abord la transmission à une puissance basse, pour éviter d'utiliser une puissance plus importante que nécessaire. Ceci à pour un but, comme la détermination de Vmax, d'assurer la sécurité de l'identification. Les premières données d'identification sont alors transmises par conduction 101 au badge 2. En outre, cela permet de diminuer la consommation énergétique du dispositif, notamment s'il est alimenté par pile, comme illustré et décrit plus loin, en référence à la figure 4.

Si le badge reçoit et reconnaît les premières données comme « vraies », il émet 102 les deuxièmes données d'identification à destination de l'unité centrale 8, en réponse aux premières données d'identification. Cette réponse 102 est faite par radiofréquence RF. Si ces deuxièmes données sont reçues et reconnues comme « vraies », l'unité centrale engage l'action prévue 105, ici l'ouverture de la portière 6 du véhicule 3. Des deuxièmes données d'identification « vraies » sont des données d'identifications en provenance d'un badge autorisé et apparenté à l'unité centrale.

Si aucune réponse RF n'est reçue on vérifie 106 si le temps Tmax est atteint ou pas. Si Tmax n'est pas atteint et si la puissance d'émission est inférieure à Vmax 107, on augmente 107 la puissance d'émission V et on émet une nouvelle fois les premières données d'identification. La puissance d'émission V est ainsi progressivement augmentée jusqu'à ce que Tmax ou Vmax soit atteint ou qu'une réponse RF soit reçue. Lorsque Tmax ou Vmax est atteint sans que l'indentification ait été complétée, la procédure d'identification est interrompue et l'unité centrale retourne dans un état de veille, en attente d'être réactivée par le capteur 7, lors d'un contact suivant.

Seulement si une réponse RF comportant des deuxièmes données d'identification « vraies » est reçue avant que Tmax et Vmax soient dépassés, l'identification est considérée complète et l'action 105 d'ouverture de la portière est déclenchée directement ou indirectement par l'unité centrale 8.

La veille du capteur capacitif et celle de l'unité centrale 8 sont peu consommatrices d'énergie. Comme illustré à la figure 4, le capteur capacitif 7 et l'unité centrale 8 peuvent donc être alimentées par pile 71. Ils peuvent constituer avec la pastille un ensemble 478 qui peut notamment être monté en tant que pièce rapportée sur la portière d'un véhicule non équipé avec l'invention, ce véhicule comprenant, par exemple, un récepteur 80 prévu initialement pour une télécommande en vue de l'ouverture du véhicule. L'ensemble 478 peut être configuré 8 pour émettre un signal un signal vers le badge un signal 111 équivalent à celui de la télécommande initialement prévue pour l'ouverture du véhicule. Ce signal est émis une fois l'identification complétée, comme décrit en référence à la figure3.

Bien sûr, l'invention n'est pas limitée aux exemples qui viennent d'être décrits et de nombreux aménagements peuvent être apportés à ces exemples sans sortir du cadre de l'invention.

Ainsi, plutôt que d'être au format carte de crédit, le badge peut être, par exemple, intégré à une clef, prévue pour être introduite dans une serrure, pour un autre mode d'ouverture d'une portière.

## Revendications

1. Procédé d'identification d'un porteur de badge (2) relativement à un véhicule (3), le véhicule comprenant une électrode de contact (4) accessible au contact du porteur, procédé dans lequel: - on compare un premier seuil (C1) avec une capacitance (C) entre l'électrode et une masse; puis, - si la capacitance est supérieure au premier seuil, on émet des premières données d'identification depuis une unité centrale (8) vers le badge; les premières données d'identification étant émises par conduction au travers du corps du porteur du badge, **caractérisé en ce qu'**on compare la capacitance avec un deuxième seuil (C2), puis : - si la valeur de capacitance est supérieure au deuxième seuil, on règle la puissance maximale (Vmax) de transmission des premières données à une première valeur maximale (V1) de transmission ; - si la valeur de capacitance est comprise entre le premier seuil (C1) et le deuxième seuil (C2) on règle la puissance maximale (Vmax) de transmission des premières données à une deuxième valeur maximale (V2) de transmission, la deuxième valeur maximale (V2) étant supérieure à la première valeur maximale (V1) ; - puis, on transmet les premières données d'identification, jusqu'à ce que l'on reçoive des deuxièmes donnée d'identifications ou qu'un temps limite (Tmax) soit atteint.

2. Procédé selon la revendication 1, **caractérisé en ce que** la puissance de transmission est progressivement augmentée jusqu'à réception des deuxièmes données d'identification ou jusqu'à atteindre la puissance maximale de transmission (Vmax).

3. Procédé selon l'une des revendications 1 ou 2, **caractérisé en ce que** lorsque le badge reçoit les premières données d'identification, et si les premières données sont « vraies », il émet des deuxièmes données d'identification sous forme d'ondes radios.

4. Procédé selon la revendication 3, **caractérisé en ce que** si les deuxièmes données d'identification sont « vraies », on déclenche une action.

5. Procédé selon la revendication 4, **caractérisé en ce que** l'action est une action de déverrouillage, notamment une action de démarrage ou d'ouverture pour le véhicule.

6. Dispositif d'identification d'un porteur de badge relativement à un véhicule, **caractérisé en ce que** le dispositif comprend une électrode de contact prévue pour être disposée accessible (4) au contact du porteur, et un capteur (7), ledit capteur comprenant des moyens pour comparer un premier seuil (C1) avec une capacitance (C) entre l'électrode et une masse du véhicule ;

7. Dispositif selon la revendication 6, **caractérisé en ce qu'**il comprend en outre une unité centrale (8), ladite unité centrale comprenant des moyens pour émettre des premières données d'identification vers un badge (2).

8. Dispositif selon la revendication 7, **caractérisé en ce que** les moyens pour émettre les premières données d'identification sont conçus pour émettre les premières données d'identification par conduction au travers de l'électrode de contact.

9. Dispositif selon la revendication 7 ou 8, **caractérisé en ce que** le capteur (7) comprend en outre des moyens pour comparer la valeur de la capacitance à un deuxième seuil (C2) et des moyens (7) pour régler une puissance maximale d'émission (Vmax) des premières données d'identification de sorte que : - si la valeur de capacitance est supérieure au deuxième seuil, la puissance maximale (Vmax) de transmission des premières données est égale à une première valeur maximale (V1) de transmission ; - si la valeur de capacitance est comprise entre le premier seuil (C1) et le deuxième seuil (C2) la puissance maximale (Vmax) de transmission des premières données est égale à une deuxième valeur maximale (V2) de transmission, la deuxième valeur maximale (V2) étant supérieure à la première valeur maximale (V1) ;

10. Dispositif selon l'une des revendications 7 à 9, **caractérisé en ce que** le badge comprend des moyens de stockage de deuxièmes données d'identification et des moyens d'émission pour les deuxièmes données d'identification sous forme d'ondes radios.

11. Dispositif selon la l'une des revendications 7 à 10, **caractérisé en ce que** l'unité centrale (8) comprend en outre des moyens pour déclencher au moins indirectement une action si les deuxièmes données d'identifications sont vraies.

12. Dispositif selon l'une des revendications 7 à 11, **caractérisé en ce que** le capteur et/ou l'unité centrale sont alimentés des moyens autonomes, notamment par pile.

13. Dispositif selon l'une des revendications 7 à 12, **caractérisé en ce que** l'unité centrale comprend des moyens pour émettre des ondes adaptées pour commander un récepteur d'une télécommande.
